Europäisches Patentamt

European Patent Office

Office européen des brevets

(19)

(11) Numéro de publication: **0 312 470**
A1

## (12) DEMANDE DE BREVET EUROPEEN

(21) Numéro de dépôt: 88420334.0

(22) Date de dépôt: 05.10.88

(51) Int. Cl.⁴: **H 01 L 29/78**
H 01 L 21/82, H 01 L 29/62

(30) Priorité: 08.10.87 FR 8714155

(43) Date de publication de la demande:
19.04.89 Bulletin 89/16

(84) Etats contractants désignés: **DE FR GB IT NL**

(71) Demandeur: **Mingam, Hervé**
**242, Chemin des Jacobins**
**F-38330 Saint Ismier (FR)**

(72) Inventeur: **Mingam, Hervé**
**242, Chemin des Jacobins**
**F-38330 Saint Ismier (FR)**

(74) Mandataire: **de Beaumont, Michel**
**1bis Rue Champollion**
**F-38000 Grenoble (FR)**

(54) **Structure de transistor à effet de champ à grille métallique isolée et procédé de fabrication.**

(57) L'invention concerne les circuits intégrés incorporant des transistors à effet de champ à grille isolée.

Pour la réalisation de la grille (G1, G2) de ces transistors, on propose d'utiliser une superposition d'une couche de chrome (48) et d'une couche de tungstène (50) qui s'avère particulièrement bien adaptée à résoudre non seulement le problème général de la conductivité électrique de la grille utilisée en tant qu'élément conducteur mais aussi les problèmes spécifiques des grilles prises en tant qu'éléments de commande de transistors. Ces problèmes sont en particulier la compatibilité physico-chimique entre le matériau de grille et l'isolant de grille qui est très mince et ne doit pas être détérioré ; et aussi la possibilité d'obtenir des tensions de seuil adéquates de transistors à canal P et à canal N sans dopages de canal nuisibles au bon fonctionnement (surtout en technologie CMOS).

Figure 6

EP 0 312 470 A1

Description

## STRUCTURE DE TRANSISTOR A EFFET DE CHAMP A GRILLE METALLIQUE ISOLEE ET PROCEDE DE FABRICATION

La présente invention concerne les circuits intégrés, et plus particulièrement les circuits qui comportent des transistors à effet de champ à grille isolée.

Ces circuits sont généralement réalisés selon une technologie dite "technologie MOS", (Métal-Oxyde-Semiconducteur), dans laquelle l'isolant de grille du transistor à grille isolée est constitué par une couche mince d'oxyde de silicium.

Les technologies "MOS" peuvent se diviser en technologies "NMOS", dans lesquelles les transistors ont une source, un drain, et un canal de type N, en technologies "PMOS", dans lesquelles les transistors ont une source, un drain, et un canal de type P, et enfin en technologies "CMOS", dans lesquelles on rencontre sur le même substrat de circuit intégré des transistors des deux types.

La présente invention présente un intérêt tout particulier dans le cas des technologies CMOS mais elle est applicable aussi aux autres technologies.

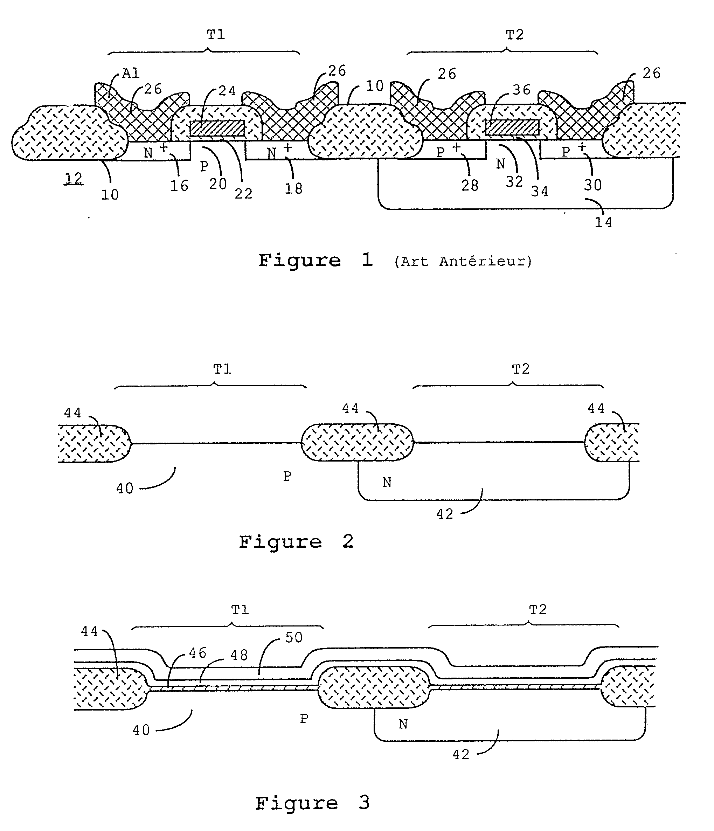

La figure 1 représente en coupe la structure habituelle d'un couple de transistors de types opposés réalisés en technologie CMOS. Les transistors sont désignés par T1 (transistor à canal N) et T2 (transistor à canal P). Chaque transistor est réalisé dans une zone active respective isolée des zones actives voisines par de l'oxyde de silicium épais désigné par la référence 10. Le transistor T1 est formé directement dans un substrat semiconducteur 12 de type P, tandis que le transistor T2 est formé à l'intérieur d'un caisson 14 de type N diffusé à partir de la surface du substrat 12.

Le transistor T1 comporte une région de source 16 de type N+ diffusée dans le substrat 12, une région de drain 18 également de type N+ diffusée dans le substrat et séparée de la région de source, et, entre les régions de drain et de source, une région de canal 20. La région de canal est recouverte par une couche isolante mince 22 qui est en pratique réalisée par de l'oxyde de silicium ; cette couche isolante est elle-même recouverte par une grille de commande 24. Enfin, les régions de source et de drain sont le plus souvent raccordées à des conducteurs métalliques déposés 26 qui servent à réaliser les interconnexions nécessaires entre les divers éléments du circuit intégré.

De la même façon, le transistor T2 comporte une région de source 28 et une région de drain 30, toutes deux de type P, diffusées dans le caisson 14, et, entre elles, une région de canal 32. La région de canal est recouverte d'une couche isolante mince 34 (oxyde de silicium) elle-même recouverte d'une grille de commande 36. Les régions de source et de drain sont également en principe raccordées à des conducteurs métalliques d'interconnexion désignés par la référence 26.

L'invention concerne plus spécialement la constitution des grilles de commande 24 et 36.

Dans les technologies les plus courantes que l'on utilise aujourd'hui, les grilles de commande sont réalisées par une couche de silicium polycristallin fortement dopée de type N, déposée sur la couche mince d'oxyde isolant (22, 34 sur la figure 1).

Le silicium polycristallin présente beaucoup d'avantages pour la réalisation des grilles et on maîtrise bien aujourd'hui les techniques de dépôt et de gravure de ce matériau. Parmi les avantages qui sont essentiels pour la réalisation d'un circuit intégré, il y a le fait que ce matériau est bien compatible mécaniquement et chimiquement avec l'oxyde de silicium sur lequel il repose. Par ailleurs il résiste bien aux traitements à température élevée que subit le circuit intégré après le dépôt du silicium polycristallin (notamment au cours de la diffusion des régions de source et de drain). D'autre part, il peut servir de masque lors de l'implantation d'impuretés destinées à la formation des régions de source et de drain, ce qui permet de réaliser des transistors dont les régions de source et de drain sont automatiquement alignées avec la grille de commande.

Ces caractéristiques sont essentielles pour la réalisation de circuits intégrés de bonnes performances et tout matériau de grille devrait les posséder.

Malheureusement le silicium polycristallin présente deux types d'inconvénients.

Le premier inconvénient est lié à sa conductivité électrique qui n'est pas très élevée : si la grille présente une certaine longueur, elle aura une résistance non négligeable qui nuit notamment à la rapidité de fonctionnement du circuit ; en effet, la grille du transistor présente une capacité importante du fait que, pour le bon fonctionnement du transistor, elle n'est isolée du substrat que par la couche isolante très mince ; la combinaison de cette résistance et de cete capacité entraîne l'apparition de constantes de temps non négligeables ralentissant le fonctionnement du circuit. Ceci est d'autant plus sensible que le matériau de grille sert aussi à réaliser localement des interconnexions entre cette grille et d'autres éléments de circuit. Ces interconnexions ne font qu'augmenter les résistances présentes dans le circuit.

Pour augmenter la conductivité du matériau de grille, on dope fortement le silicium avec des impuretés de type N, mais l'amélioration n'est que partielle.

On a aussi proposé de recouvrir le silicium polycristallin d'une couche de siliciure métallique (siliciure de tungstène, de titane, de platine, etc.) ; l'amélioration est très sensible mais, là encore, elle n'est que partielle. De plus, certains siliciures tels que le siliciure de tungstène ne sont pas inertes vis-à-vis de l'oxyde de silicium sous la grille. Or, l'inertie physico-chimique du matériau de grille vis-à-vis de l'isolant de grille d'un transistor à effet de champ est essentielle pour le bon fonctionnement de ce dernier.

On a également proposé d'utiliser comme matériau de grille des métaux purs tels que du tungstène dont la conductivité est très bonne, mais ce métal s'adapte mal à un dépôt sur de l'oxyde de silicium ; des tentatives ont d'ailleurs été faites pour améliorer son adhérence en bombardant l'oxyde de silicium avant le dépôt du tungstène pour créer des défauts facilitant l'accrochage. Mais cela détériore de manière inacceptable l'oxyde de grille.

Un deuxième inconvénient apparaît par ailleurs lorsqu'on réalise une grille de commande de transistor : c'est le problème de la tension de seuil que présente le transistor, c'est-à-dire la tension minimale nécessaire entre grille et source pour que le transistor devienne conducteur. Cette tension dépend entre autres choses du matériau utilisé pour la grille de commande, et plus précisément de la nature du matériau qui est en contact avec l'oxyde isolant situé sous la grille.

Dans les technologies CMOS courantes avec un oxyde de grille de 250 angströms d'épaisseur environ, la tension de seuil naturelle des transistors à canal N serait très voisine de zéro volt pour les transistors à canal N à grille de silicium polycristallin fortement dopé de type $N^+$ et elle serait d'environ -1,2 volt pour les transistors à canal P ayant le même matériau de grille (ces valeurs sont données à titre indicatif car elles dépendent de beaucoup de paramètres, mais c'est celles que l'on rencontre fréquemment).

Il serait souhaitable pourtant que la tension de seuil des transistors à canal N soit légèrement positive pour que ces transistors ne soient pas conducteurs en présence d'une tension nulle sur leur grille (sauf cas particuliers où l'on réalise volontairement des transistors déplétés dont la tension de seuil est même rendue négative).

Pour parvenir à ce résultat, on adopte le plus souvent la solution consistant à surdoper légèrement avec une impureté de type P la région de canal des transistors à canal N. Si ce surdopage est effectué sur toute la surface du substrat semiconducteur, c'est-à-dire aussi bien sur les transistors à canal N que sur les transistors à canal P (ce qui évite une opération de masquage), on peut aboutir à un compromis acceptable dans lequel les transistors à canal N ont une tension de seuil positive de + 0,8 volt et les transistors à canal P ont une tension de seuil de - 0,8 volt.

Dans ces conditions, pour une tension grille-source nulle, ces transistors ne conduisent pas de courant. Cependant, on constate que l'implantation d' une impureté (de type P) dans la région de canal des transistors à canal P entraîne l'apparition d'un courant de fuite entre drain et source, courant de fuite qui était négligeable en l'absence de cette implantation mais qui peut devenir inacceptable en présence de cette implantation, notamment lorsque le canal est très court ( et on cherche à réduire toujours plus les dimensions des transistors pour miniaturiser les circuits) et si la tension entre drain et source est importante (par exemple 5 volts, ce qui est très classique dans les circuits de technologie CMOS).

Pour résoudre ce problème, on pourrait réaliser la grille en silicium polycristallin dopé de type P ; mais alors on reporte sur les transistors à canal N le problème qui vient d'être mentionné pour les transistors à canal P, car il devient nécessaire de contre-doper le canal des transistors à canal N, c'est-à-dire qu'il devient nécessaire d'implanter une impureté de type N dans ce canal, ce qui augmente le courant de fuite à tension grille-source nulle.

Bien entendu on comprendra qu'il est souhaitable d'utiliser le même matétiau de grille pour les transistors à canal P et les transistors à canal N réalisés sur un même substrat (technologie CMOS), faute de quoi on augmenterait fâcheusement le nombre d'étapes nécessaires à la réalisation de circuits intégrés dans cette technologie.

La présente invention a pour but de résoudre au mieux le problème de la conductivité des grilles de commande ainsi que le problème des tensions de seuil des transistors en technologie CMOS et des courants de fuite engendrés par les opérations d'ajustement de seuil, ceci tout en conservant l'ensemble des caractéristiques qui faisaient l'intérêt pratique des grilles à base de silicium polycristallin et de siciliures métalliques, et notamment : la facilité de dépôt et de gravure, la compatibilité mécanique, physique et chimique avec l'oxyde de silicium, le caractère réfractaire pour les traitements à haute température, la possibilité de servir de masque lors de l'implantation de source et de drain.

Pour y parvenir, la présente invention propose d'utiliser comme matériau de grille une couche de tungstène superposée à une couche de chrome.

Cette superposition résout de manière très satisfaisante non seulement le problème de l'amélioration de la conductivité de la grille prise en tant qu'élément de connexion électrique mais surtout l'ensemble des problèmes spécifiques aux grilles prises en tant qu'électrodes de commande de transistor à effet de champ, problèmes dont on a exposé ci-dessus la complexité.

De préférence, la couche de chrome est beaucoup plus mince que la couche de tungstène. Par exemple, la couche de chrome peut avoir une épaisseur de quelques centaines d'angströms au plus tandis que la couche de tungstène peut avoir une épaisseur de plusieurs milliers d'angströms. Des valeurs typiques seraient par exemple de 300 angströms et 4000 angströms, respectivement, pour la couche de chrome et la couche de tungstène.

Bien entendu, pour une structure en technologie CMOS, les grilles des transistors à canal N comme les grilles de transistors à canal P seraient réalisées au moyen de cette superposition.

La réalisation se ferait par la succession d'opérations suivantes :
- dépôt d'une couche de chrome sur la structure sur laquelle a été formé au préalable l'isolant de grille, le dépôt se faisant par exemple par pulvérisation ;
- dépôt d'une couche de tungstène immédiatement après, de préférence aussi par pulvérisation et si possible dans le même bâti de pulvérisation que celui qui a servi pour le chrome, la structure de circuit intégré n'étant pas mise à l'air libre entre les deux dépôts pour éviter toute oxydation de la couche de chrome ;
- masquage photolithographique et gravure du tungstène, en principe dans une machine à gravure ionique réactive, en présence d'un plasma n'attaquant pas le chrome (par exemple un plasma fluoré tel qu'un plasma d'hexafluorure de soufre SF6) ;
- gravure du chrome (sans nécessité d'un masquage photolithographique) là où il n'est plus recouvert par le tungstène, le motif de tungstène qui subsiste servant alors de masque de gravure protégeant le chrome présent sous ce motif.

Les étapes suivantes de la fabrication peuvent être les étapes classiques utilisées pour les circuits à grille en silicium polycristallin, et notamment l'étape d'implantation ionique, masquée par le motif de tungstène/chrome, d'impuretés servant à la formation de régions de source et de drain autoalignées par rapport à la grille.

D'autres caractéristiques et avantages de l'invention apparaîtront à la lecture de la description détaillée qui suit et qui est faite en référence aux dessins annexés dans lesquels :

- la figure 1, déjà décrite, représente simplement la structure classique d'un couple de transistors de types opposés formés sur un même substrat semiconducteur ;

- les figures 2 à 6 représentent la structure de circuit intégré selon l'invention à différents stades de sa fabrication ;

- les figures 7 à 9 représentent une variante du procédé selon l'invention ; et

- la figure 10 représente une résistance fabricable lors de la mise en oeuvre de la variante illustrée en figures 7 à 9.

On notera que les diverses figures, conformément à l'usage dans la représentation des circuits intégrés, ne sont pas tracées à l'échelle, ni à l'intérieur d'une figure, ni d'une figure à l'autre. En effet, les diverses dimensions ont été arbitrairement dilatées et retrécies pour faciliter la lisibilité et simplifier la représentation.

On va décrire un procédé pratique de réalisation de transistors à effet de champ selon l'invention, à partir d'un exemple en technologie CMOS.

On part d'un substrat semiconducteur 40 qui peut être par exemple un substrat de silicium ou une couche de silicium déposée sur un substrat isolant. Dans l'exemple choisi, le substrat est de type P.

On implante des impuretés de type N aux endroits où devront être formés des transistors à canal P ; cette implantation et les diffusions thermiques ultérieures aboutissent à la formation de caissons 42 de type N dans le substrat 40. Puis, on délimite classiquement des zones actives séparées par de l'oxyde de silicium épais 44.

Sur la figure 2, on a représenté la structure de circuit intégré à ce stade de la fabrication, avec une première zone active désignée par T1 pour contenir un transistor à canal N, et une deuxième zone active désignée par T2 pour contenir un transistor à canal P ; la deuxième zone T2 est située à l'intérieur d'un caisson 42 de type N.

On fait croître par oxydation thermique une couche mince 46 d'oxyde de silicium (épaisseur de 250 angströms par exemple) ; cette couche recouvre uniformément les zones actives, aussi bien à la surface des caissons 42 qu'en dehors des caissons.

On dépose uniformément une couche mince de chrome 48, par exemple de 300 anströms d'épaisseur, sur toute la surface de la structure.

Ce dépôt est suivi d'un dépôt uniforme, également sur toute la surface du substrat, d'une couche de tungstène 50, dont l'épaisseur est par exemple de 4000 angströms environ.

La figure 3 représente la structure de circuit-intégré à ce stade de la fabrication.

Le dépôt est effectué par exemple dans un bâti de pulvérisation cathodique à deux cibles, l'une de chrome et l'autre de tungstène, la première cible étant utilisée dans un premier temps et la deuxième dans un deuxième temps ; la structure n'est pas sortie du bâti entre les deux phases de pulvérisation si on désire minimiser les risques d'oxydation de la surface supérieure de la couche de chrome déposée pendant la première phase.

On effectue alors une photogravure de la double couche tungstène/chrome pour définir le motif de grilles et d'interconnexions à réaliser à l'aide de cette double couche. Pour cela on dépose classiquement une résine photosensible que l'on insole à travers un masque correspondant au motif désiré et que l'on développe pour laisser subsister la résine seulement aux endroits où l'on désire conserver la double couche de tungstène/chrome.

On élimine le tungstène là où il n'est pas protégé par la résine ; cette opération est effectuée par exemple dans une machine de gravure ionique réactive en présence d'un plasma fluoré (SF6 notamment). Le chrome n'est pas attaqué par cette opération de sorte qu'on détermine facilement le moment où la gravure de tungstène est terminée.

On élimine alors le chrome là où il a été dénudé, dans un bain chimique n'attaquant pas le tungstène ni l'oxyde de silicium de la couche mine 46, par exemple du sulfate de cérium.

Il subsiste alors des îlots de matériau conducteur en double couche correspondant d'une part aux grilles des transistors à réaliser et d'autre part à certaines interconnexions conductrices (soit pour connecter les grilles à d'autres éléments de circuit, soit pour connecter d'autres éléments de circuit entre eux).

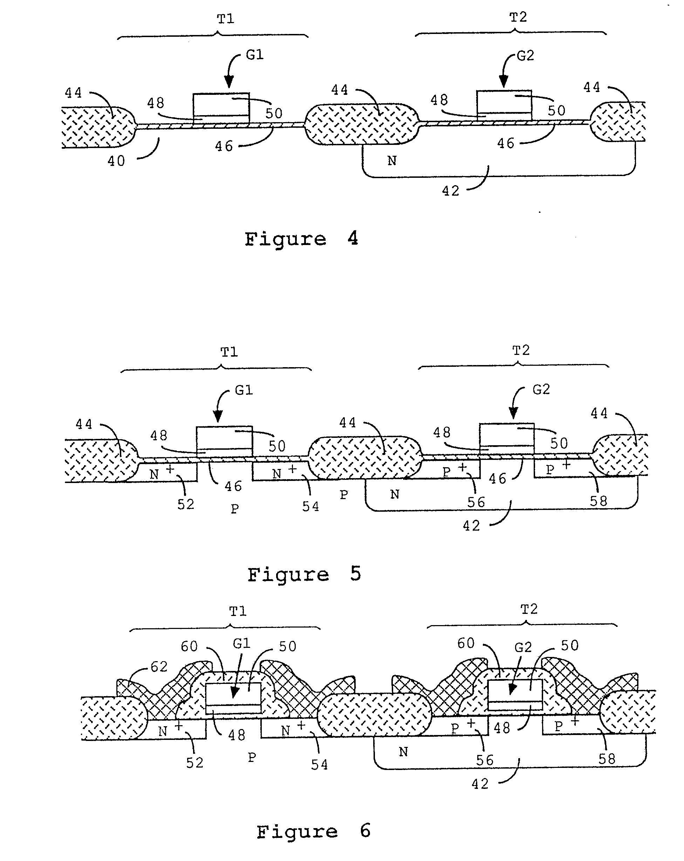

La figure 4 représente la structure de circuit intégré à ce stade de la fabrication ; on n'a représenté que deux îlots G1 et G2 correspondant respectivement à la grille du transistor T1 et à la grille du transistor T2.

On procède alors à l'implantation d'impuretés pour former les régions de source et de drain autoalignées par rapport aux grilles des transistors.

Dans une première phase, on peut masquer les transistors à canal P par une résine et implanter une impureté de type N pour former les régions de source 52 et de drain 54 des transistors à canal N ; dans une deuxième phase, après avoir enlevé la résine, on masque par une nouvelle couche de résine les transistors à canal N et on implante une impureté de type P pour former les régions de source 56 et de drain 58 des transistors à canal P.

Pendant ces étapes d'implantation, les grilles de tungstène/chrome constituent un excellent masque de sorte que les régions de source et de drain peuvent être auto-alignées par rapport aux bords des grilles.

Par un recuit thermique on fait diffuser les régions implantées à l'intérieur du substrat 40 et du caisson 42. les grilles se comportent très bien pendant ce recuit car les matériaux utilisés supportent les hautes températures habituellement atteintes lors des diffusions d'impuretés.

La figure 5 représente le circuit intégré à ce stade de la fabrication après enlèvement de l'autre couche de résine.

Le reste du procédé de fabrication est classique et ne sera pas décrit en détail ; il peut comprendre le dépôt d'une couche d'oxyde de silicium 60 et la gravure de cette couche pour former des ouvertures de contact d'accès aux régions de source et de drain et éventuellement des ouvertures de contact d'accès à certains îlots de la double couche de tungstène/chrome. Puis on dépose et on grave une couche conductrice d'interconnexion 62 qui peut être de l'aluminium mais qui peut être aussi une couche à base d'autres matériaux, y compris si on le désire une double couche tungstène/chrome similaire à celle utilisée pour les grilles.

La figure 6 représente la structure de circuit intégré à ce stade de la fabrication.

Enfin, on dépose une couche isolante de protection sur l'ensemble de la structure (couche de passivation non représentée) et il ne reste plus qu'à ouvrir dans cette couche des ouvertures correspondant aux plots de soudure de fils de connexion.

Les grilles de transistors à effet de champ ainsi réalisées sont très bien compatibles, du point de vue mécanique et aussi du point de vue de réactions physico-chimiques, avec l'oxyde de silicium sous-jacent.

Leur conductivité est excellente : la résistivité de couche, évaluée en ohms par carré est environ dix fois plus faible que celle du couple siliciure de tungstène/silicium polycristallin (pour des épaisseurs équivalentes). On peut facilement envisager d'augmenter le nombre d'interconnexions réalisées par la couche servant à la réalisation des grilles : auparavant, certaines interconnexions ne pouvaient pas être réalisées à ce niveau à cause de la conductivité trop faible des matériaux utilisés.

Enfin, les propriétés physiques du chrome, et notamment son "potentiel d'extraction d'électrons vers le vide" qui est de 4,8 électron-volts, sont telles qu'on peut obtenir une tension de seuil des transistors à canal N d'environ + 0,45 volt et une tension de seuil des transistors à canal P d'environ - 0,75 volt, ceci sans opération de dopage du canal, et surtout sans opération de dopage qui introduirait dans le canal une impureté du même type que la source et le drain (contre-dopage).

On a décrit ci-dessus un exemple simplifié de réalisation complète d'un circuit intégré avec des grilles selon l'invention, mais on comprendra que des procédés plus complexes puissent être utilisés sans sortir du cadre de l'invention ; par exemple, il est classique de prévoir que les régions de source et de drain des transistors comprennent à la fois une partie profonde et très fortement dopée éloignée des bords de la grille et une partie peu profonde et moins dopée immédiatement adjacente aux bords de la grille.

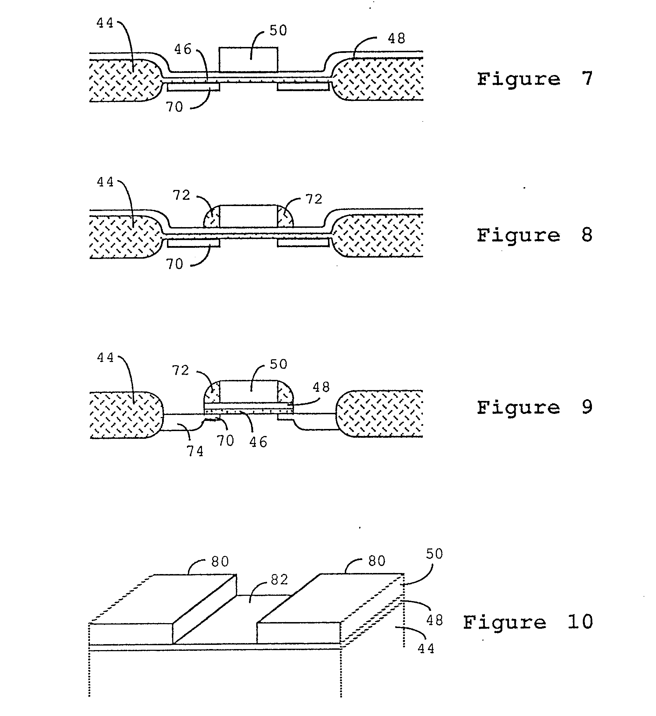

Pour obtenir une telle allure de diffusion de source et de drain, en partant de la structure de la figure 3, on attaque comme cela a été indiqué ci-dessus la couche de tungstène 50. Mais, au lieu de procéder immédiatement après à une attaque correspondante de la couche de chrome 48, on procède à une implantation ionique à travers cette couche de chrome très mince d'un dopant à une concentration moyenne, par exemple $10^{13}$ atomes par $cm^3$. Une telle implantation peut être réalisée de façon classique en raison de la très faible épaisseur de la couche de chrome 48 qui est par exemple d'une épaisseur de l'ordre de 300 Å comme cela a été indiqué précédemment. En outre, le plot de tungstène 50 constitue une excellente barrière à l'encontre de l'implantation. On obtient ainsi la structure illustrée en figure 7 dans laquelle on peut voir les couches implantées peu profondes et moyennement dopées 70.

Ensuite, comme le représente la figure 8, on réalise des espaceurs en oxyde de silicium 72 par des techniques classiques de dépôt de $SiO_2$ et de contre-gravure. En utilisant la couche de tungstène restante 50 et les espaceurs 72 comme masques, on élimine alors la couche de chrome 48 et éventuellement la couche mince d'oxyde de silicium 46. On procède alors à une implantation plus profonde dans les zones où seront formés les contacts de source et de drain pour fournir la structure finalement illustrée en figure 9 comprenant les zones d'implantation plus profondes 74 et les zones moins profondes et moins dopées 70.

On notera que le procédé illustré en figures 7 à 9 ressemble à des procédés similaires réalisés dans le cas de grilles polycristallines. Toutefois, par rapport à ces procédés classiques, le procédé selon l'invention présente des avantages notables.

Un premier avantage est que, dans le cas d'une grille en silicium polycristallin, on était amené, pour avoir une structure similaire à celle de la figure 7, à former des plots de silicium polycristallin épais en laissant en place une couche mince de silicium polycristallin. Une telle étape est complexe technologiquement en fabrication industrielle car la durée d'attaque doit être minutée avec précision et varie avec divers paramètres technologiques. Par contre, selon la présente invention, l'attaque du tungstène s'arrête automatiquement quand on arrive sur la couche de chrome.

D'autre part, les procédés utilisant des grilles de silicium polycristallin nécessitaient pour l'étape susmentionnée de gravure partielle de silicium polycristallin de prévoir des masques de nitrure à l'emplacement de la grille où l'on veut maintenir en place le silicium polycristallin épais et ceci constitue toujours une étape technologique complexe.

Un troisième avantage du procédé de la présente invention réside dans le fait que ce procédé permet de former simultanément des résistances de forte valeur en d'autres emplacements du circuit intégré comme ceci est illustré en figure 10.

A la figure 10, on a représenté, par exemple au dessus d'une zone d'oxyde épais 44, la couche mince de chrome 48 revêtue de la couche de tungstène 50. Lors de l'étape de gravure sélective du tungstène, correspondant à l'étape de la figure 7, on a laissé en place des plots ou bandes de tungstène 80 gravés pour laisser en place entre eux une bande de chrome 82 de dimensions choisies. Etant donné la forte résistivité du chrome liée à sa faible épaisseur (de l'ordre de 300 Å) on peut ainsi réaliser avec précision des résistances de valeurs élevées. On notera que cette forte résistivité du chrome qui constitue un avantage pour cette fabrication d'une résistance ne constitue pas un inconvénient au niveau des grilles puisque, dans ce cas là, la couche de chrome très mince est utilisée dans le sens transverse et n'est pas parcourue par un courant notable.

**Revendications**

1. Struture de circuit intégré comportant des transistors à effet de champ à grille isolée, caractérisée en ce que la grille (G1, G2) de ces transistors est constituée d'une couche de tungstène (50) superposée à une couche de chrome (48).

2. Structure de circuit intégré selon la revendication 1, caractérisée en ce qu'elle comporte des transistors à canal P (T2) et des transistors à canal N (T1) sur un même substrat, ces deux types de transistors ayant des grilles constituées d'une couche de tungstène superposée à une couche de chrome.

3. Structure de circuit intégré selon l'une des revendications 1 et 2, caractérisée en ce que la couche de chrome (48) est beaucoup plus mince que la couche de tungstène (50).

4. Structure de circuit intégré selon la revendication 3, caractérisée en ce que la couche de chrome (48) a une épaisseur de quelques centaines d'angströms au plus et la couche de tungstène (50) une épaisseur d'environ quelques milliers d'angströms.

5. Procédé de réalisation d'une structure de circuit intégré comportant des transistors à effet de champ à grille isolée, caractérisé en ce que l'on effectue la succession d'opérations suivantes pour la réalisation des grilles (G1, G2) de ces transistors :

a) dépôt d'une couche de chrome (48) sur la structure sur laquelle a été préalablement formé un isolant de grille (46),

b) dépôt d'une couche de tungstène (50) immédiatement après,

c) masquage photolithographique et gravure du tungstène selon un motif correspondant aux grilles de transistors à effet de champ à réaliser et à certaines interconnexions, et

d) élimination du chrome là où il n'est plus recouvert de tungstène par suite de l'opération précédente.

6. Procédé de réalisation d'une structure de circuit intégré selon la revendication 5, caractérisé en ce qu'il comprend, entre les étapes c) et d), les étapes suivantes :

- implanter un premier dopant (70),

- former latéralement des espaceurs (72), par exemple en oxyde de silicium.

7. Procédé de réalisation d'une structure de circuit intégré selon l'une des revendications 5 ou 6, caractérisé en ce qu'il comprend en outre les étapes consistant à prévoir, en dehors des zones de transistors à effet de champ à grille isolée, des bandes dans lesquelles le tungstène est gravé localement et le chrome laissé en place pour former des résistances (82).

T1                          T2

A1
26                    26        26
24            26                      36                26
12
N +        P          N +              P +         N         P +
10      16  20 22    18            28   32 34        30
14

**Figure 1** (Art Antérieur)

T1                          T2

44              44                        44
40          P          N
42

**Figure 2**

T1                          T2

44      46  48    50
40          P          N
42

**Figure 3**

Figure 4

Figure 5

Figure 6

Figure 7

Figure 8

Figure 9

Figure 10

Office européen
des brevets

# RAPPORT DE RECHERCHE EUROPEENNE

Numero de la demande

EP 88 42 0334

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 672 419 (McDAVID)<br>* Résumé; figures 1-4; colonne 2, ligne 11 - colonne 3, ligne 7 *<br>--- | 1,3-6 | H 01 L 29/78<br>H 01 L 21/82<br>H 01 L 29/62 |
| A | GB-A-2 181 456 (D.W. WOODRUFF)<br>* Résumé; page 1, lignes 40-46; page 3, ligne 63 - page 4, ligne 9; tableau 1 *<br>--- | 1,3,4 | |
| A | IEEE TRANSACTIONS ON ELECTRON DEVICES, vol. ED-29, no. 12, Décembre 1982, pages 1900-1905, IEEE, New York, US; M.D. JHABVALA et al.: "A monolithic lead sulfide-silicon MOS integrated-circuit structure"<br>* Résumé; paragraphes 2,3 *<br>--- | 1,2,5 | |
| A | IBM TECHNICAL DISCLOSURE BULLETIN, vol. 29, no. 4, septembre 1986, pages 1854-1856, New York, US; "Adhesion enhancement of thin metal film"<br>* Page 1855, exemple I *<br>--- | 1 | |
| A | PATENT ABSTRACTS OF JAPAN, vol. 8, no. 8 (E-221)[1445], 13 janvier 1984; & JP-A-58 171 852 (HITACHI SEISAKUSHO K.K.) 08-10-1983<br>* Résumé *<br>--- | 1,3,4 | DOMAINES TECHNIQUES RECHERCHES (Int. Cl.4)<br><br>H 01 L 29 |
| A | IBM TECHNICAL DISCLOSURE BULLETIN, vol. 25, no. 5, octobre 1982, page 2294, New York, US; J.S. JASPAL et al.: "Non-diffused chip resistors"<br>* En entier *<br>----- | 7 | |

Le présent rapport a été établi pour toutes les revendications

| Lieu de la recherche | Date d'achèvement de la recherche | Examinateur |
|---|---|---|
| LA HAYE | 20-01-1989 | MIMOUN B.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.............................................................................
& : membre de la même famille, document correspondant

EPO FORM 1503 03.82 (P0402)